# EUROPEAN PATENT APPLICATION

(11) **EP 2 051 306 A1**
(43) Date of publication of application: **22.04.2009**
(21) Application number: 08425585.0
(22) Date of filing: 03.09.2008
(51) Int. Cl.: H01L 31/042, F24J 2/54, H01L 31/048, H01L 31/052

(54) **Photovoltaic generator with solar tracking integrated into support structure**

(30) Priority: 15.10.2007 IT VI20070280
(71) Applicant: Beghelli S.p.A., 40050 Monteveglio, Bologna (IT)
(72) Inventor: Beghelli, Gian Pietro, 40050 Monteveglio (Bologna) (IT)
(74) Representative: Iannone, Carlo Luigi

(57) **Abstract**

An photovoltaic generator (1) with movable photovoltaic modules (3,4) for solar tracking, including a series of photovoltaic panels (2), each of which includes a set of photovoltaic modules (3,4), which are fixed to a support structure so that each module (3,4) is able to rotate around its median axis; all the photovoltaic modules (3,4) are moved by a single drive engine (24), whose operation is controlled by an electronic integrated control and conversion device (7), which also incorporates a DC/AC converter (inverter), necessary to inject electricity into the power network (22). In particular, the overall structure of the generator (1) is designed so as to provide a very compact and thin solar tracker.

## Description

The present invention relates to an autonomous photovoltaic generator with movable photovoltaic modules for the solar tracking.

The photovoltaic generators usually consist of flat panels composed of silicon cells arrays, connected in series one with each other and also connected with an electronic converter, suitable to convert the direct electric current (DC) of the cells into alternate current (AC) collectable from the low-voltage power network for the operation of the generator.

The flat photovoltaic modules may be mounted above the so-called "solar trackers", i.e. devices consisting of mobile frames, whose orientation varies during the day in order to keep the panels constantly oriented toward the sun.

Although this technological solution allows to increase the production of photovoltaic electricity, however the resulting structure presents a significant dimension and a relevant aesthetic impact.

In addition, the cost of the moving devices, presenting a non-negligible incidence on the total cost of the system, often risks to thwart the advantages deriving from the greater electricity production.

As part of the abovementioned requirements, therefore, the main aim of the present invention is to overcome the drawbacks mentioned above and, in particular, is to provide an autonomous photovoltaic generator with movable photovoltaic modules for the solar tracking, which allows to obtain a significant reduction of the costs of production of the photovoltaic panels and of the entire system of production of electricity.

Another aim of the present invention is to carry out an autonomous photovoltaic generator with movable photovoltaic modules for the solar tracking, which can be installed without needing specific expertises beyond those ones of a normal electrical installer.

Further aim of the present invention is to provide an autonomous photovoltaic generator with movable photovoltaic modules for the solar tracking, which can be integrated and with independent structure, which can be installed in modular manner.

These and other aims are achieved by an autonomous photovoltaic generator with movable photovoltaic modules for the solar tracking, according to the attached claim 1.

Other technical features of detail are reported in the following claims.

In an advantageous way, in order to overcome the drawbacks of the traditional photovoltaic generation systems with solar tracking moving and obtain a reduction of the costs of production of such systems, the autonomous photovoltaic generator has been developed, with micro-movable photovoltaic modules, subject of the current invention.

Further aims and benefits of an autonomous photovoltaic generator with movable photovoltaic modules for the solar tracking, according to the present invention, will be more evident from the description that follows, related to illustrative and preferred, but not limiting, embodiments of the autonomous photovoltaic generator object of the invention, and from the attached drawings, in which:
- figure 1 shows a whole perspective view of an autonomous photovoltaic generator with movable photovoltaic modules for the solar tracking, according to the present invention;
- figure 2A is a top view of a single panel of the autonomous photovoltaic generator of figure 1, consisting of three photovoltaic modules and assembled in a "tank" structure for the embedding integration of the panel in a flat cover, according to the present invention;
- figure 2B is a first side view of the panel of figure 2A, according to the present invention;
- figure 2C is a further side view of the panel of figure 2A, according to the invention;
- figure 2D is a top perspective view of a single panel of the autonomous photovoltaic generator of figure 1, consisting of three photovoltaic modules and assembled in a "tank" structure for the embedding integration of the panel in a sloped cover, according to an alternative embodiment of the present invention;
- figure 2E is a cutting view, which shows the mechanical moving members of the panel of figure 2D, according to the present invention;
- figure 3A is a top view of a single photovoltaic module which can be used in the panels of figures 1 and 2A-2E, according to the invention;
- figure 3B is a side view of the photovoltaic module shown in figure 3A;
- figure 3C is a perspective view of the photovoltaic module shown in figure 3A;
- figure 4 is a perspective view of the photovoltaic module referred to figures 3A-3C, used in an solar concentration construction in which a quantity of silicon halved in comparison with the previous ones is used, thanks to the presence of side mirrors with triangular profile;
- figures 5A-5E show a series of enlarged particulars of the moving system of the photovoltaic modules mounted on the autonomous photovoltaic generator object of the present invention;
- figure 6 shows a block diagram of the electronic control and conversion device connected with the autonomous photovoltaic generator of the present invention.

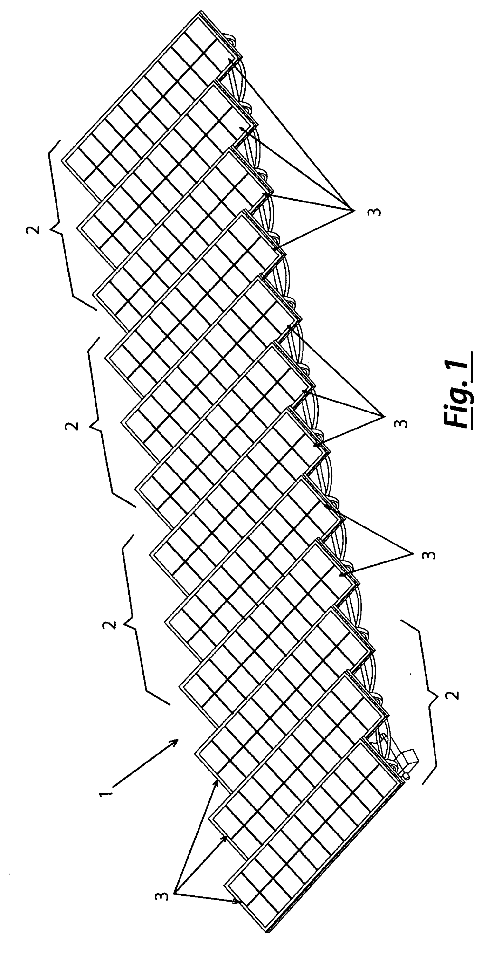

With particular reference to the attached figure 1, the autonomous photovoltaic generator object of the current invention and as a whole referred with 1, includes, in an illustrative and preferred, but not limiting, embodiment, a series of four panels, each of which, indicate with 2, consists of three photovoltaic modules 3, for a total of twelve photovoltaic modules 3 for each generator 1.

In particular, the photovoltaic modules 3, of which consisted the generator 1, are bound to a lower support structure, suitable to allow the rotation of each module 3 around its own median axis.

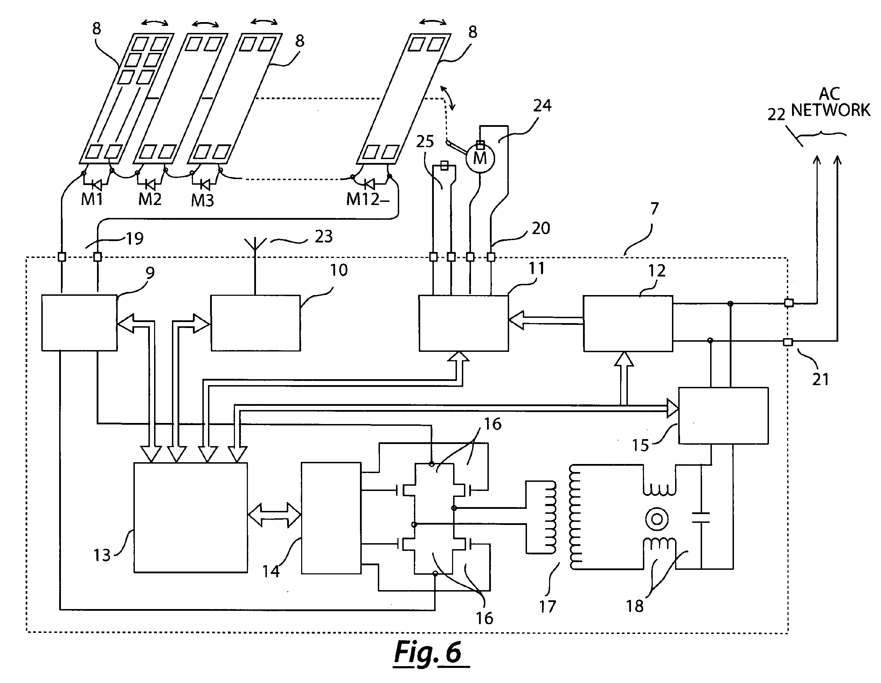

All modules are moved by a single engine (indicated with 24 in the block diagram of figure 6) and the aforesaid engine 24 is controlled by an electronic integrated device, overall indicated with 7 in figure 6, which also incorporates the DC/AC converter (inverter), necessary to inject the electricity into the network.

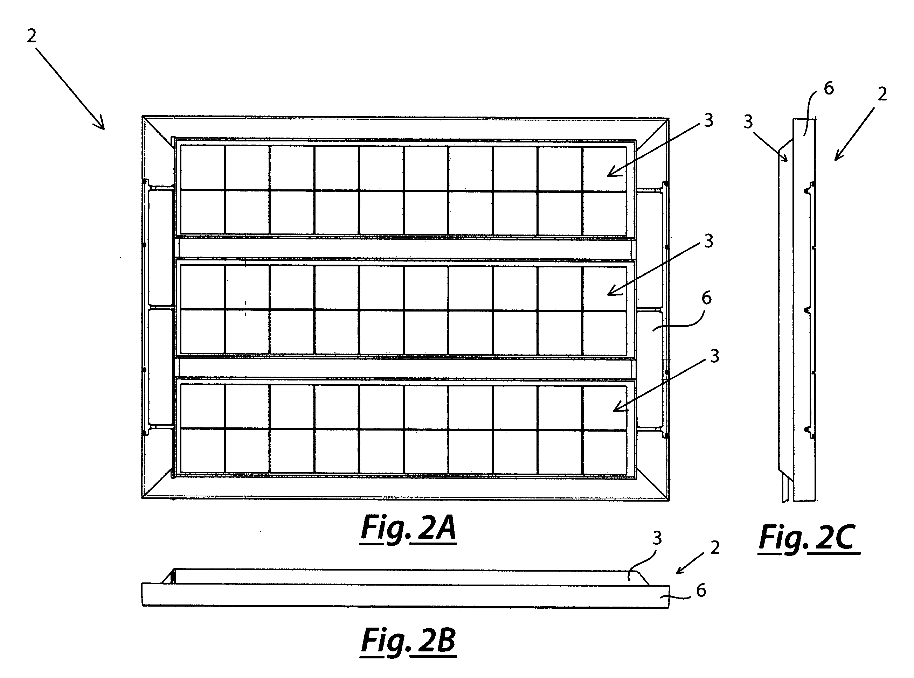

Figures 2A-2E show a constructive solution of a photovoltaic panel 2, where the support of the three modules 3 is carried out by a structure, which can easily be embedded in a cover 6 of a flat or sloped roof, creating the necessary protection for the rain and allowing an even greater integration of the modules 3 inside the cover 6.

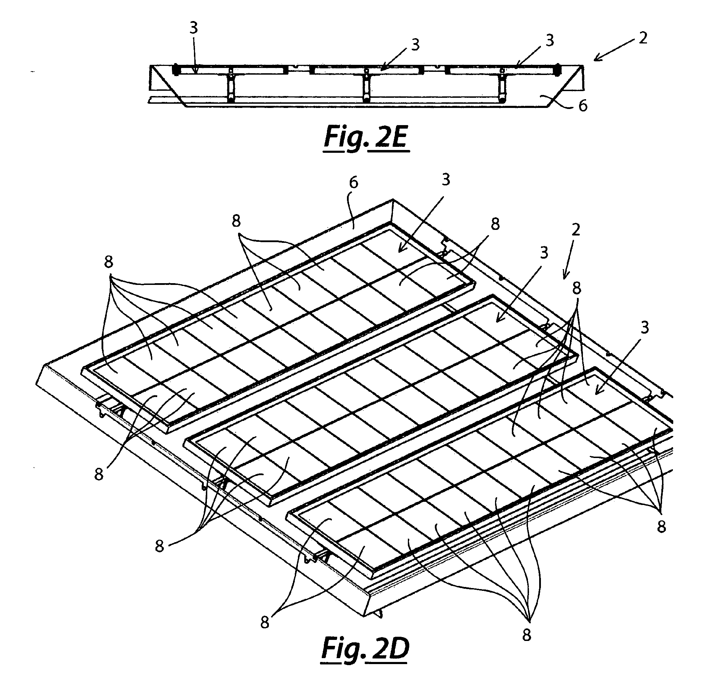

In this case, the photovoltaic modules 3 are completely integrated aesthetically into the cover 6 and, in particular, in the rest horizontal position shown in figures 2A, 2D and 2E, the modules 3 are coplanar to the upper surface of the structure of the cover 6.

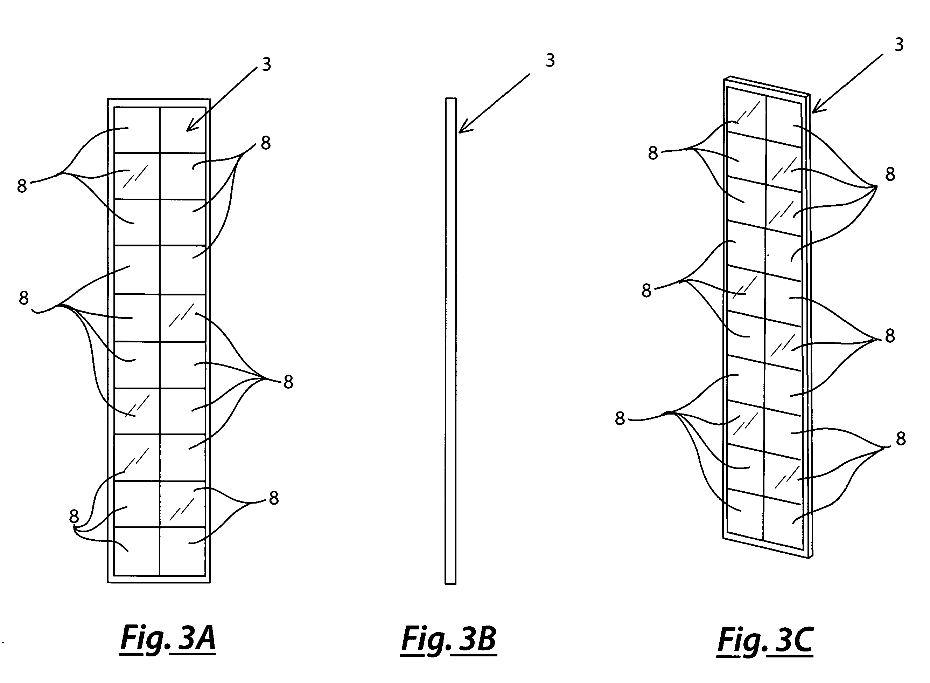

In figures 3A-3C it is reported the single photovoltaic module 3, which, in the illustrative case shown here, consists of twenty silicon cells, each of which indicated with 8, polycrystalline or single-crystalline, for example having a 156x156 mm size.

Such a photovoltaic module 3 is characterized by a power peak of about 75 Watt, with maximum power output voltage (Vmpp) of about 9,5 Volts and maximum power output electric current (Impp) of about 7,8 Ampere.

The module 3 is built according to the known assembly technique of the cells 8 in a pile consisting of glass, EVA, photovoltaic cells, EVA, Tedlar, the complex being then rolled at a temperature of about 150°C; the overall dimensions of each module 3 are 1645x355x35 mm.

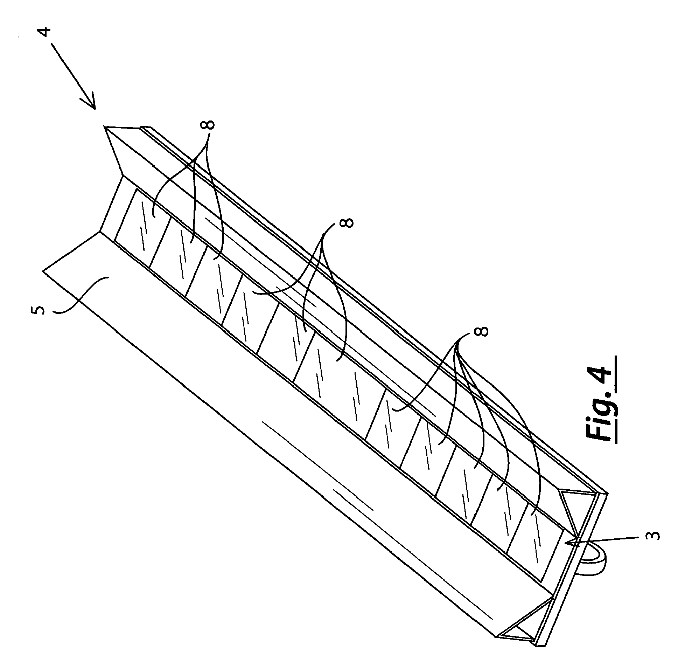

Figure 4 shows a photovoltaic module 4 of the low concentration type, consisting of twelve single-crystalline or polycrystalline silicon cells 8, each of which having for example a 125x125mm size, and two concentrators devices, each of which denoted with 5, of the linear type.

This module 4 has a peak power of about 58 Watt, a maximum power output voltage (Vmpp) of about 6 volts and a maximum power output electric current (Impp) of about 9,7 Ampere.

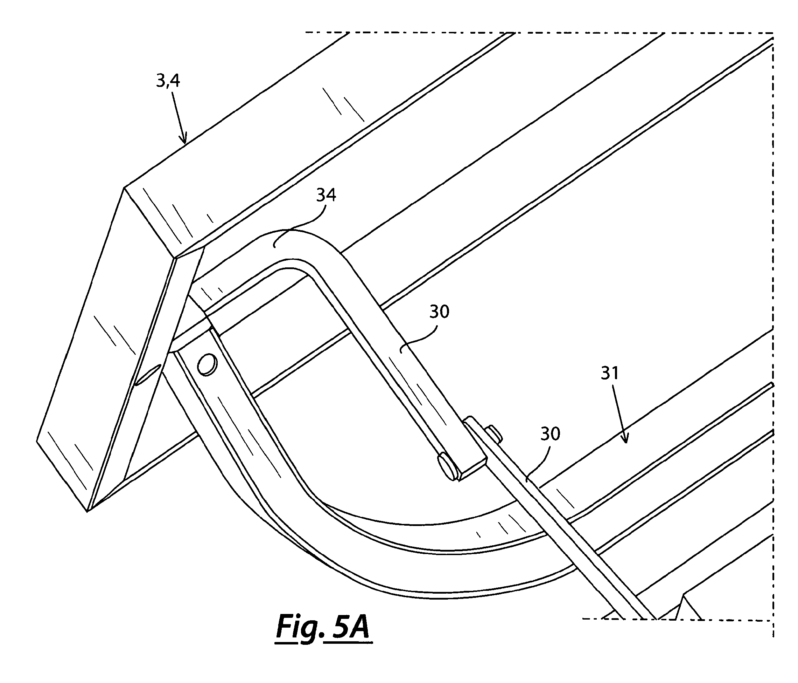

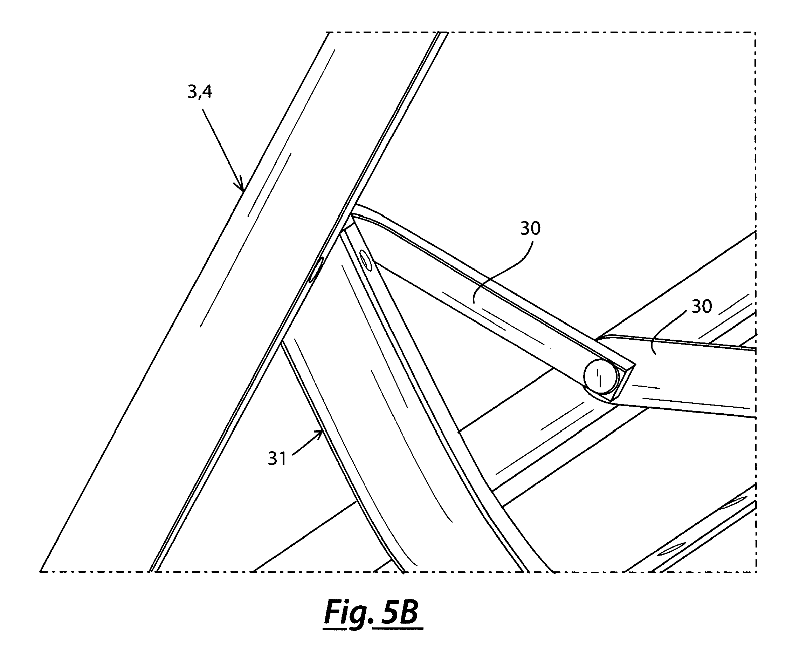

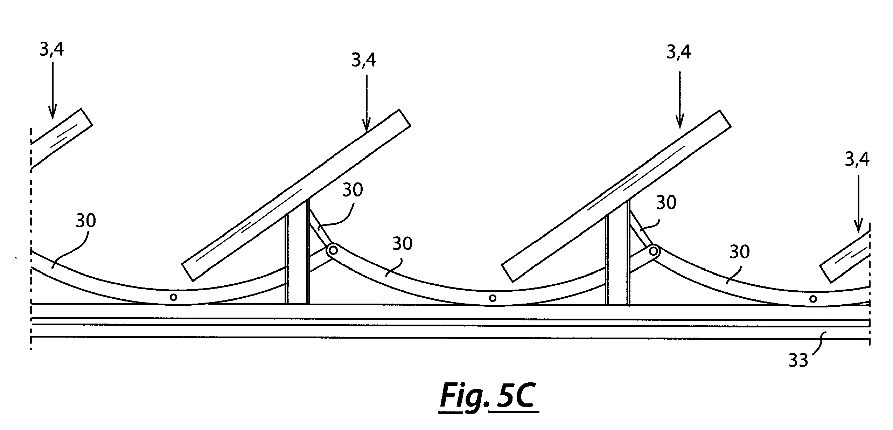

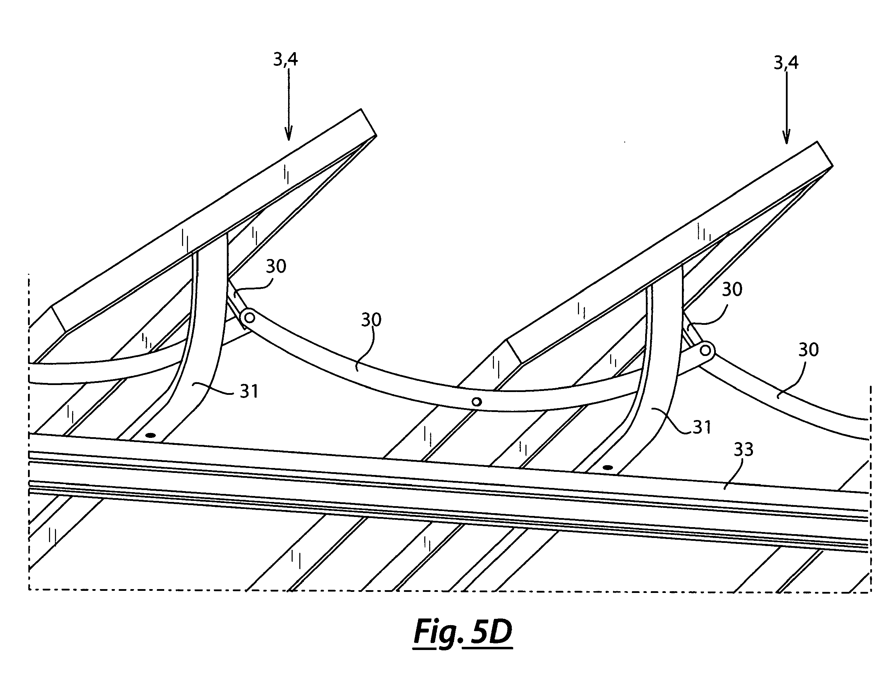

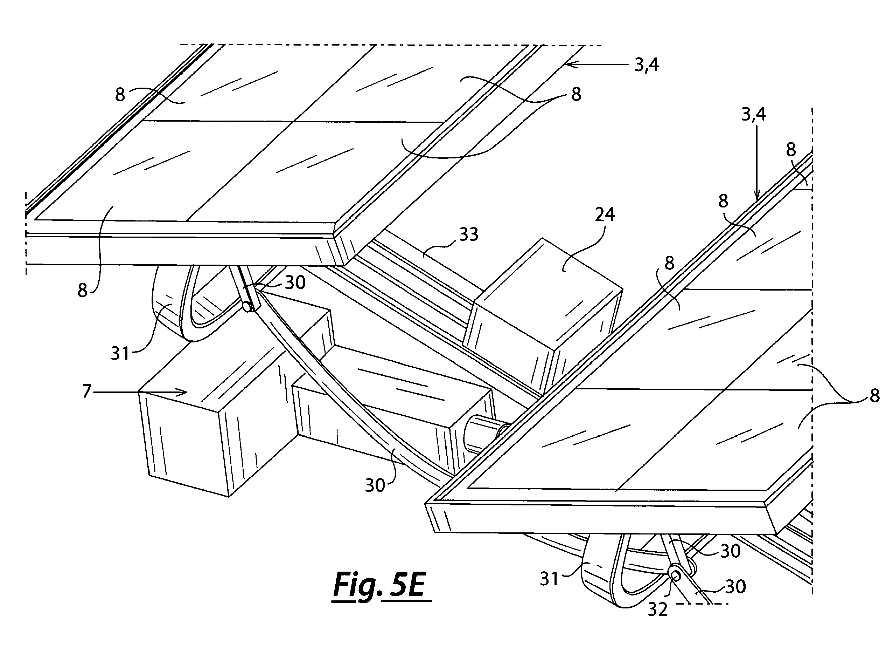

In figures 5A-5D it is highlighted the support system on pins 34, which allows the rotation of the photovoltaic modules 3, 4 around their own median axis, as well as the system of rods and cranks 30 and brackets 31, which allow the synchronous movement of all the modules 3, 4, of the generator 1, while in figure 5E it is highlighted the drive engine 24, fixed on the bar 33, suitable to rotate the various photovoltaic modules 3, 4 of the generator 1 and the electronic control and conversion device 7, which incorporates a control unit of the engine 24 and the inverter.

The functioning of the autonomous photovoltaic generator 1, according to the current invention, is substantially as follows.

Firstly, the generator 1 can be installed on flat or sloped towards the south, south-east or south-west roofs. During the functioning, the photovoltaic modules 3, 4 are rotated in order to chase the solar apparent motion from east to west and in order to always keep themselves orthogonal to the rays of the sun as much as possible.

The modules 3, 4 may be spaced apart of a height variable between 20% and 100% of their size, that is between about 7 cm and 35 cm, depending on the installation requirements.

In order to obtain these performances, an algorithm of control of the drive engine 24 is, in particular, used, equipped with back-tracking technology, which avoids the damaging effect of the shadows when the sun slant is greater than the maximum slant of the photovoltaic modules 3, so that relative shadows do not generate among the modules themselves.

Once reached this condition, the engine 24 reverses the motion so that at dawn and at sunset the modules 3 are in almost horizontal position to avoid that the shadings of the modules themselves block the functioning.

In this way it is possible to maintain the modules 3, 4 at a minimum distance one between the other, keeping the advantage of an increased production of electricity, in comparison with fixed modules; in this regard, a greater energy production over a calendar year is estimated, at the latitudes of our country, included between 15% and 30%, which depends on the slant north-south of the generator 1 and on the distance among the various modules 3, 4.

With particular reference to the attached figure 6, which illustrates a block diagram of the autonomous photovoltaic generator 1, according to the invention, the aforesaid generator 1 consists of the following components:
- twelve photovoltaic modules of the kind of those ones indicated with 3 and 4;
- an engine 24, for example of the direct current (DC) and low voltage kind or of the brushless type or of the stepper type, with the respective, for example at Hall effect, encoder, marked with 25;
- an electronic control device 7, which incorporates the control unit 24 of the engine 24 and the DC/AC converter.

In relation to the inner architecture of the electronic control device 7, the aforesaid control device 7 is equipped with three connectors 19, 20, 21, provided for, respectively, the input of electricity from the photovoltaic modules 3, 4, for the connection with the engine 24 and for the output of electricity towards the power network 22.

The electronic device 7 is also controlled by a microcontroller 13, which runs:
- an input interface 9, which incorporates an antijamming filter and the conditioning circuits for the measurement of the DC electrical power generated by the photovoltaic modules 3, 4;
- a radio interface 10, provided with an antenna 23, of the FH-DSSS type, acting for example in the 2,4-2483 GHz frequency band;
- a driver 11 for piloting the engine 24, including the interface circuits for the encoder 25 and the measurement of the engine displacement;
- a driver 14 of the transistors 16 of the inverter, at full bridge, for the conversion DC/AC;
- a transformer 17, at the frequency network, for the fitting of the output tension of the photovoltaic modules 3, 4 to the network tension and for the galvanic isolation;
- an output section of antijamming filter 18;
- a sectioning circuit 15 towards the network 22, comprising any part of measuring the output power;
- a switching feeder 12, at high efficiency, for the supply by the electric network 22 of the vital parts of the electronic control device 7 in absence of the sunlight and for the supply of the engine 24.

The technical solution proposed in the present invention utilizes for the converter DC/AC a single stage pattern (transistors 16 and transformer 17) with the use of a 50 Hz low frequency transformer 17.

This solution has the advantage, for not high (<1.000 Watt) cuts of power, to assure high efficiency, while offering at the same a low cost and not excessive dimension and weights.

Indeed, the transformer 17 can be of toroidal type, so as to allow to achieve a high compactness and a high efficiency (>97,5%); the presence of a transformer 17 in base band (at 50 Hz) permits, also, to have a complete separation between the photovoltaic modules 3, 4 and the electric network 22, avoiding from the beginning the problem of possible injections of direct current (DC) into the network.

The result is a converter DC/AC particularly compact and efficient for these cuts power, which does not require even the need for a switching conversion two-stage, with additional advantages in terms of reliability and cost.

The microcontroller 13 implements a MPPT algorithm for seeking the maximum power working point of the photovoltaic modules 3, 4 and, furthermore, by simultaneously controlling the engine 24 and the DC/AC converter, implements a special bidimensional MPPT algorithm, which seeks the maximum power point not only by varying the power absorbed by the photovoltaic modules 3, 4, but also by varying the slant of the modules themselves.

It is clear, indeed, from studies and carried out experimental tests that the maximum power supplied by the generator 1 is not always directly linked to the tracking towards the astronomical position of the sun.

In fact, the maximum power generated by the photovoltaic panels 2 depends on the relationship between the direct solar radiation and the diffused solar radiation, and in case of prevalence of the latter, the best pointing is not that one towards the position of the sun; thanks to the bidimensional MPPT algorithm mentioned above is thus possible to increase the amount of energy produced through the system described.

The two-way radio 10 allows to carry out a series of system functions, such as the antitheft function.

Such a function is carried out, in this case, by measuring the electrical continuity of the connection with the photovoltaic modules 3, 4 through a high frequency impedance measurer circuit embedded into the block 9 and by sending via radio an alarm signal in case of lack of electrical continuity.

This function is active throughout the day, and even at night, provided that network electricity is present.

At system level, a management exchange of the whole system (not shown in the present description) periodically checks (for example every minute) the presence of all the electronic devices 7 connected with it via radio and, when lacking the answer from at least one device 7, actives an alarm procedure; this allows to get an anti-theft function even when a suspicious-looking person disconnects the power supply network 22 of the generator 1.

Indeed, since the system exchange is provided with optional storage batteries, it can work properly even in absence of the electricity of the network 22 and generate the appropriate anti-theft alarm signals.

From the description made the characteristics of the autonomous photovoltaic generator with movable photovoltaic modules for the solar tracking, which is the object of the present invention, are clear, as well as the resulting benefits.

In particular, the proposed solution offers the advantage of providing a very compact and small in thickness solar tracker.

Indeed, even when the photovoltaic modules are sloped in order to offer the maximum possible surface to the sun, the generator, as a whole, maintains a very compact shape, with all the aesthetic and functional advantages which follow from it, with respect to the traditional solutions available on the market.

In particular, the small surface of the single photovoltaic module allows to reduce the sail effect and, therefore, allows to lighten the systems of support and bond to the support surfaces, with consequent reductions of cost and ease of installation.

It is, finally, clear that several other variations may be made to the photovoltaic generator in question, without for this reason going out of the novelty principles inherent to the inventive idea, as it is clear that, in the practical implementation of the invention, materials, shapes and sizes of the details could be any, depending on the needs, and could be replaced with others technically equivalent.

## Claims

1. Autonomous photovoltaic generator (1) with movable photovoltaic modules (3, 4) for the solar tracking, comprising a series of photovoltaic panels (2), each of which includes a set of photovoltaic modules (3, 4), which are bound to a lower support structure so that each module (3, 4) is able to rotate around its median axis, said photovoltaic modules (3, 4) being moved, according to micrometric steps, by a single drive engine (24), whose operation is controlled by an electronic integrated control and conversion device (7), which incorporates at least one unit control of the drive engine (24) and at least one DC/AC converter or inverter necessary to inject electricity into the power network (22).

2. Autonomous photovoltaic generator (1) as claim 1, **characterized in that** it includes a series of four panels (2), each consisting of three photovoltaic modules (3, 4), for a total of twelve photovoltaic modules (3, 4).

3. Autonomous photovoltaic generator (1) as claim 1, **characterized in that** said support structure of the photovoltaic modules (3, 4) can be embedded within at least one cover (6) of a flat or sloped roof, said photovoltaic modules (3, 4) being integrated into the cover (6) and resulting, in the rest position, coplanar to the upper surface of said cover (6).

4. Autonomous photovoltaic generator (1) as claim 1, **characterized in that** each photovoltaic module (3, 4) presents a plurality of single-crystalline or polycrystalline silicon cells (8), assembled in a pile consisting of glass, EVA, cells, EVA, Tedlar.

5. Autonomous photovoltaic generator (1) as claim 1, **characterized in that** each module photovoltaic (3, 4) presents at least one concentrator device (5), of the linear type.

6. Autonomous photovoltaic generator (1) as claim 1, **characterized in that** said support structure includes a series of pins (34), which allow the rotation of the photovoltaic modules (3, 4) around its own median axis, and a rods/cranks (30) and brackets (31) system, which allow the synchronous movement of all the photovoltaic modules (3, 4) of the generator (1).

7. Autonomous photovoltaic generator (1) as claim 1, **characterized in that** said drive engine (24) is fixed on a bar (33) of the support structure and is suitable to rotate the various photovoltaic modules (3, 4) .

8. Autonomous photovoltaic generator (1) as claim 1, **characterized in that** said photovoltaic modules (3, 4) are spaced apart one each other by a height variable between 20% and 100% of their size.

9. Autonomous photovoltaic generator (1) as claim 1, **characterized in that** said electronic control device (7) comprises a series of connectors (19, 20, 21) provided for the input of the electricity from the photovoltaic modules (3, 4), for the connection with the drive engine (24) and for the output of the electricity towards the power network (22), a microcontroller (13) for the control of an input interface (9), including antijamming filters and conditioning and measurement circuits of the electrical power generated by the photovoltaic modules (3, 4), of a radio interface (10), of a pilot circuit (11) of the drive engine (24), of a pilot circuit (14) of the transistors (16) of the inverter, at full bridge, for converting DC/AC, of a transformer (17), operating at the network frequency, for the fitting of the output tension of the photovoltaic modules (3, 4) to the network tension and for the galvanic isolation, of an output filtering section (18), of a sectioning circuit (15) towards the electrical power network (22), of a switching feeder (12) for the supply of the electronic control device (7) in absence of sunlight and for the supply of the drive engine (24).

10. Autonomous photovoltaic generator (1) as claim 9, **characterized in that** said microcontroller (13) implements a MPPT algorithm for seeking the maximum power working point of the photovoltaic modules (3, 4).

11. Autonomous photovoltaic generator (1) as claim 9, **characterized in that** said microcontroller (13), by controlling contemporaneously the drive engine (24) and the DC/AC converter, implements a bidimensional MPPT algorithm, which seeks the maximum power point by varying the power absorbed by the photovoltaic modules (3, 4) and the slant of said photovoltaic modules (3, 4).

12. Autonomous photovoltaic generator (1) as claim 9, **characterized in that** said radio interface (10) allows to carry out a series of system functions, such as an antitheft function, which is obtained by measuring the electrical continuity of the connection to the photovoltaic modules (3, 4) and transmitting via radio, through optional supply batteries, an alarm signal in case of lack of electrical continuity, a function of periodic control of the presence of all the electronic devices (7) connected via radio and an alarm function in case of disconnection of the electrical power network (22) of the generator (1).
